(19) Europäisches Patentamt
European Patent Office
Office européen des brevets

(11) EP 2 282 358 A1

(12) EUROPEAN PATENT APPLICATION

(43) Date of publication:
**09.02.2011 Bulletin 2011/06**

(51) Int Cl.:
***H01L 51/00*** *(2006.01)*

(21) Application number: **09167477.0**

(22) Date of filing: **07.08.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(71) Applicant: **Solvay SA**
**1050 Brussels (BE)**

(72) Inventors:
- **Maunoury, Jonathan**
  **1030 Brussels (BE)**
- **Bascour, Dominique**
  **1180 Uccle (BE)**
- **Ferrand, Alexandre**
  **1040 Etterbeek (BE)**

(74) Representative: **Jacques, Philippe et al**
**Solvay S.A.**
**Département de la Propriété Industrielle**
**Rue de Ransbeek, 310**
**1120 Bruxelles (BE)**

# (54) Host material for light-emitting devices

(57) The present invention relates to the use of an oxadiazole-based compound as an electron transporting material in an emissive layer of an OLED. Surprisingly, it has been found that when the oxadiazole-based compound of the present invention is used in the emissive layer, the solution process is available in preparing OLED without any adverse effect on the OLED performance. The present invention further relates to an OLED comprising the oxadiazole-based compound.



Printed by Jouve, 75001 PARIS (FR)

## Description

## Technical Field

The present invention relates to the use of an oxadiazole-based compound as a host material in an emissive layer and an organic light-emitting device comprising the oxadiazole-based compound. The present invention also relates to a process for manufacturing the organic light-emitting device.

## Background

Recently, various display devices have been under active study and development, particularly those based on electroluminescence (EL) from organic materials.

Organic light emitting devices (OLEDs) can be classified into fluorescence-based OLEDs and phosphorescence-based OLEDs according to the luminescent process of materials. The process of fluorescence occurs between states of equal symmetry, i.e., between excited state and ground state of singlet excitons. On the contrary, the process of phosphorescence occurs through the transition between singlet state and triplet state. Phosphorescence may persist up to several seconds after excitation due to the low probability of the transition, in contrast to fluorescence which shows rapid decay. Because excitons exist as singlet and triplet states in the ratio of 1 to 3, the maximum efficiency of fluorescence is limited to 25 %, while that of phosphorescence is 75 %. While the energy contained in the triplet state is mostly wasted in the fluorescent materials, the phosphorescent materials allow for the simultaneous harvesting of both singlet and triplet excitons.

As such, the use of phosphorescent materials has been a major breakthrough in boosting electroluminescence efficiency of OLEDs.

The most widely used preparation process of OLED is carried out by vacuum evaporation, in which layers of OLED are formed on a substrate using a mask. In said process, the mask may be distorted due to the high temperature applied. Thus, it is difficult to obtain a layer with uniform surface, and the production cost for preparing large area OLEDs is highly increased. To solve the above problems, a solution process can be used, in which organic materials may be printed at a desired position without using the mask, thereby reducing the number of steps for preparation and the cost.

It is required to formulate the active components as inks for the solution process. The active components must be soluble in solvents, and polymer or small molecules may be used as the active components. However, polymers have several disadvantages. Purification of polymers is tedious. Defects in the polymeric backbone can act as charge traps, thus resulting in low efficiency. As such, small molecules are preferred because they can be purified by sublimation, as well as being designable to have a high Tg (low tendency to crystallize) and a high solubility without any impact on the electronic levels.

To enjoy both high efficiency and low production costs, phosphorescent emissive materials may be dispersed in a small molecules matrix. The matrix may comprise a hole transport molecule and an electron transport molecule to guarantee a good charge balance in the emissive layer.

Several host molecules are already known in the art. However, since most of them have a low solubility, they are used in vacuum processed OLEDs. Further, most of them have good hole mobility but low electron mobility.

Well-known host materials for guest-host systems include hole-transporting 4,4'-N,N'-dicarbazol-biphenyl (CBP) and electron-transporting aluminum 8-hydroxyquinoline ($AlQ_3$), which have both been used in OLEDs. However, the known host materials are not suitable for all phosphorescent guests. For example, the host compound for phosphorescent emitters must fulfil an important condition that the triplet energy of the host be higher than that of the phosphorescent emitter. To provide efficient phosphorescence from the phosphorescent emitter, the lowest excited triplet state of the host has to be higher in energy than the lowest emitting state of the phosphorescent emitter. Since emission from the phosphorescent emitter is desired, the lowest excited state has to be from the phosphorescent emitter, not the host compound. As such, there continues to be a need in the art for suitable host materials for guests, which have short emission wavelengths in the light spectrum, e.g., in the blue region of the spectrum.

However, none of the known host materials meet all the requirements necessary for OLED application, e.g., suitable energy level, hole and electron transporting ability, processibility from a solution with uniform film formation, ability to form an amorphous phase, ability for good dopant dispersion, morphological stability (high Tg), thermal and electrochemical stabilities under operational conditions of the device. Thus, there has been a need to develop new host materials, which are capable of satisfying all of the requirements indicated above.

## Brief Description of Drawings

Fig. 1 shows an exemplary cross-sectional view of an OLED comprising an oxadiazole-based compound of the present invention.

Fig. 2 shows the I-V-L characteristics of the OLED of the present invention and the OLED of the comparative reference.

Fig. 3 shows the luminous efficiency of the OLED of the present invention and the OLED of the comparative reference as a function of the luminance.

## Disclosure of the Invention

One aspect of the present invention relates to the use of an oxadiazole-based compound as a host material, especially as an electron transporting material in an emissive layer of an OLED. The oxadiazole-based compound can transport electrons in an emissive layer so that electrons can be combined with holes to produce excitons.

Another aspect of the present invention relates to an OLED comprising the oxadiazole-based compound.

The oxadiazole-based compound of the present invention can be represented by the following Formula I:

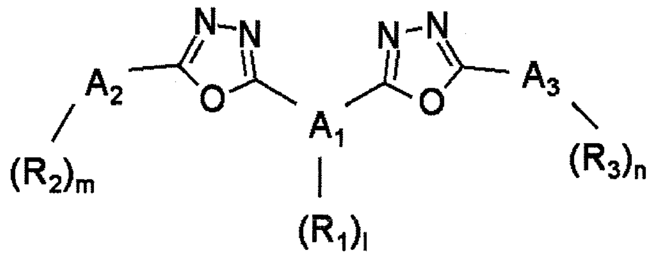

Formula (I)

wherein:

$A_1$, $A_2$ and $A_3$ are same or different at each occurrence and independently selected from the group consisting of five- or six-membered (hetero)aryl rings and fused rings;

$R_1$ is selected from the group consisting of halogen, nitro, cyano, straight or branched $C_{1-20}$-(hetero)alkyl, straight or branched $C_{2-20}$-(hetero)alkenyl, straight or branched $C_{2-20}$ -(hetero)alkynyl, $C_{3-20}$ -cyclic alkyl, straight or branched $C_{1-20}$-alkoxy, $C_{1-20}$-dialkylamino, $C_{4-14}$-(hetero)aryl and $C_{4-14}$-aryloxy, which are substitutable by one or more halogens or non-aromatic radicals;

$R_2$ and $R_3$ are same or different at each occurrence and independently selected from the group consisting of -H, halogen, nitro, cyano, straight or branched $C_{1-20}$-alkyl, straight or branched $C_{2-20}$ -alkenyl, straight or branched $C_{2-20}$ -alkynyl, $C_{3-20}$ -cyclic alkyl, straight or branched $C_{1-20}$ -alkoxy, $C_{1-20}$-dialkylamino, $C_{4-14}$ -aryl, $C_{4-14}$ -aryloxy and $C_{4-14}$ -heteroaryl, which are substitutable by one or more non-aromatic radicals, wherein a plurality of $R_1$, $R_2$ and $R_3$ may in turn together form a mono- or polycyclic ring, optionally aromatic; and

1, m and n are same or different at each occurrence and represent an integer of 1 or more.

The term "alkyl" as used herein refers to hydrocarbon radicals containing preferably 1 to 20, more preferably 1 to 10, most preferably 1 to 6 carbon atoms. Specific examples thereof include, but are not limited to, methyl, ethyl, propyl, isopropyl, butyl, *t*-butyl, pentyl, hexyl and heptyl groups.

The term "alkenyl" as used herein refers to hydrocarbon radicals having at least one double bond, containing preferably 2 to 20, more preferably 2 to 10, most preferably 2 to 6 carbon atoms. The term "alkynyl" as used herein refers to hydrocarbon radicals having at least one triple bond, containing preferably 2 to 20, more preferably 2 to 10, most preferably 2 to 6 carbon atoms.

The term "cyclic alkyl" as used herein refers to cyclic hydrocarbon radicals containing preferably 3 to 20, more preferably 3 to 10, most preferably 5 or 6 carbon atoms, which do not give steric hindrance. Specific examples thereof include, but are not limited to, cyclopentyl and cyclohexyl groups.

The term "alkoxy" as used herein refers to an alkyl group containing preferably 1 to 20, more preferably 1 to 10, most preferably 1 to 6 carbon atoms, covalently bound to an oxygen atom. Specific examples thereof include, but are not limited to, methoxy, ethoxy, propyloxy, isopropyloxy, butoxy, t-butoxy, pentyloxy, hexyloxy and heptyloxy groups.

The term "aryl" as used herein refers to carbocyclic rings with the degree of unsaturation present as to impart aromaticity to the ring. Specific examples thereof include, but are not limited to, phenyl, naphthyl, anthracenyl, biphenyl, pyrenyl and perylene groups.

The term "heteroaryl" as used herein refers to a heterocyclic aromatic ring, which can be a five-member ring

heterocycle, a six-member ring heterocycle and ring-fused bicyclic heterocycle. Specific examples thereof include, but are not limited to, pyridyl, bipyridyl, thiophene, imidazole, oxazole, thiazole and quinolinyl groups.

In some embodiments of the present invention, $A_1$ is selected from the group consisting of phenyl, naphthyl, anthryl, phenanthryl, benzimidazolyl, carbazolyl, fluorenyl, pyridazinyl, quinolinyl, isoquinolinyl, quinoxalinyl, benzothiophenyl, phthalazinyl, quinazolinyl, benzimidazolyl, benzoxazolyl and phenanthridinyl. In certain embodiments, $A_1$ is phenyl.

In some embodiments of the present invention, $A_2$ and $A_3$ are same or different at each occurrence and independently selected from the group consisting of phenyl, naphthyl, anthryl, phenanthryl, pyridyl, bipyridyl, thiophenyl, imidazolyl, oxazolyl, thiazolyl and quinolinyl. In certain embodiments, $A_2$ and $A_3$ are phenyl.

In other embodiments of the present invention, $R_1$ is straight or branched $C_{1-20}$-(hetero)alkyl, $C_{3-20}$ -cyclic alkyl and $C_{4-14}$-(hetero)aryl, which are substitutable by one or more halogen, hydroxyl, nitro, cyano, alkoxy, amino and optionally-esterified carboxyl. In certain embodiments of the present invention, $R_1$ is a *tert*-alkyl, fluorinated alkyl or fluorinated ether, and 1 is 1. In other embodiments of the present invention, fluorinated alkyl may contain alkyl spacer (e.g., ethyl) between $A_1$ (e.g., phenyl) and the fluorine-substituted carbon atom of $R_1$.

In other embodiments of the present invention, $R_2$ and $R_3$ are same or different at each occurrence and independently straight or branched $C_{1-20}$-alkyl, $C_{3-20}$ -cyclic alkyl, straight $C_{4-14}$-aryl and $C_{4-14}$ -heteroaryl. In certain embodiments, $R_2$ and $R_3$ are *tert*-butyl, and m and n are 1.

Specifically, in some embodiments of the present invention, host materials may comprise a substituted oxadiazole-7 (OXD7) as an electron transporting material. In certain embodiments, the substituted OXD7 can be represented by the following Formulae (II) (tBu-OXD7) and (III) ($C_6F_{13}$-OXD7):

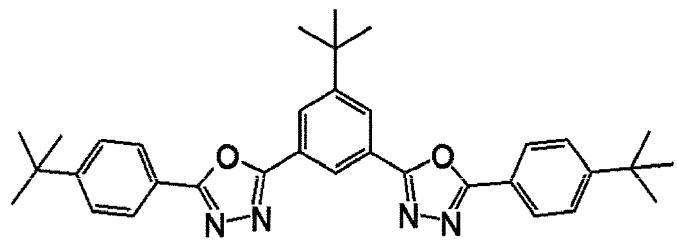

Formula (II)

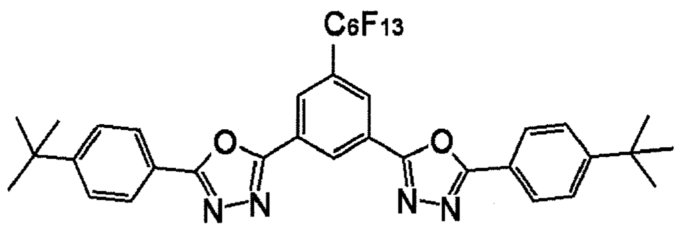

Formula (III)

Surprisingly, it has been found that when the oxadiazole based compounds of the present invention is used in an emissive layer,
a solution deposition method is available in the preparation of the device due to its high solubility and high electron mobility in the emissive layer can be achieved.

Suitable solvents used in the solution deposition method can be selected from those known in the art. In some embodiments, non-chlorinated solvents such as acetone, dimethylbenzene, ethanol and toluene can be used. In certain embodiments, toluene can be used as the solvent.

In some embodiments of the present invention, the emissive layer may comprise an additional host material, which can transport the holes in the layer. In certain embodiments, the emissive layer may comprise a carbazole derivative as a hole transporting material. The carbazole derivative may be selected from the compounds of Formula IV:

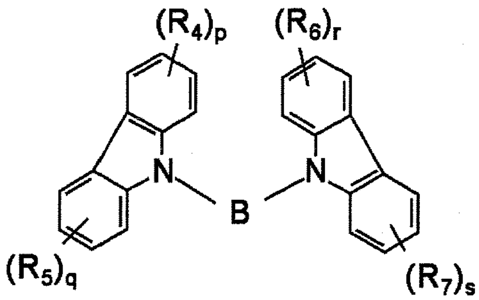

Formula (IV)

wherein:

B is an organic divalent radical;

$R_4$, $R_5$, $R_6$ and $R_7$ are non-conjugate substituents, same or different at each occurrence and selected from the group consisting of:

-H
trityl
halogen;
nitro;
cyano;
$-COOR_8$;
alkoxy or dialkylamino group having from 1 to 20 carbon atoms wherein one or more nonadjacent $-CH_2-$ groups are replaceable by -O-, -S-, $-NR_9-$, $-CONR_{10}-$ or
-COO-, and wherein at least one hydrogen atom is replaceable by halogen; and
$-SiR_{11}R_{12}R_{13}$;

wherein $R_8$, $R_9$, $R_{10}$, $R_{11}$, $R_{12}$, and $R_{13}$ are same or different at each occurrence and independently selected from the group consisting of -H, halogen, nitro, cyano, straight or branched $C_{1-20}$-alkyl, $C_{3-20}$ -cyclic alkyl, straight or branched $C_{1-20}$-alkoxy, $C_{1-20}$-dialkylamino, $C_{4-14}$-aryl, $C_{4-14}$-aryloxy and $C_{4-14}$-heteroaryl, which are substitutable by one or more non-aromatic radicals, wherein a plurality of $R_4$, $R_5$, $R_6$, $R_7$, $R_{11}$, $R_{12}$ and $R_{13}$ may in turn together form a mono- or polycyclic ring, optionally aromatic; and

p, q, r and s are same or different at each occurrence and represent an integer from 0 to 4.

In some embodiments of the present invention, B is a divalent radical comprising at least one structural unit selected from the group consisting of five-or six-membered (hetero)aryl rings and fused rings. Specifically, B is a divalent radical selected from the group consisting of phenyl, naphthyl, anthryl, phenanthryl, benzimidazolyl, carbazolyl, fluorenyl, pyridazinyl, quinolinyl, isoquinolinyl, quinoxalinyl, benzothiophenyl, phthalazinyl, quinazolinyl, benzimidazolyl, benzoxazolyl and phenanthridinyl.

In other embodiments, B is a divalent radical of Formula V:

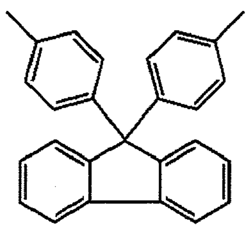

Formula (V).

In other embodiments, B is a divalent radical of Formula VI:

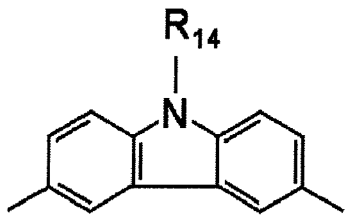

Formula (VI)

wherein $R_{14}$ is selected from the group consisting of straight or branched $C_{1-20}$-alkyl, $C_{3-20}$ -cyclic alkyl, straight or branched $C_{1-20}$-alkoxy, $C_{4-14}$-aryl, $C_{4-14}$-aryloxy and $C_{4-14}$ -heteroaryl, which are substitutable by one or more non-aromatic radicals such as, but not limited to, halogen, hydroxyl, nitro, cyano, alkoxy, amino and optionally-esterified carboxyl.

In some embodiments of the present invention, a hole transporting material can be a triscarbazole (TCz) derivative including, but not limited, the following compounds represented by Formulae (VII) (TCzF) and (VIII) (TCzl):

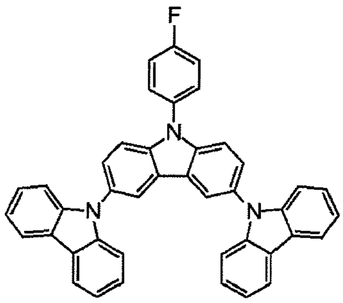

Formula (VII)

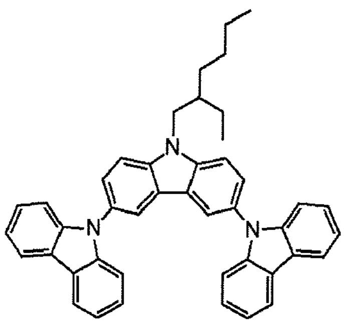

Formula (VIII)

Further, certain embodiments of the present invention may be the following compounds represented by Formulae (IX) to (XVI):

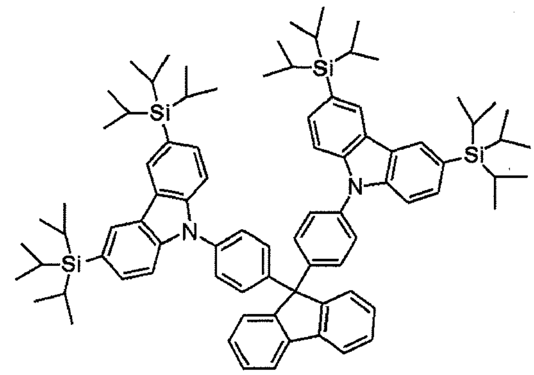

Formula (IX),

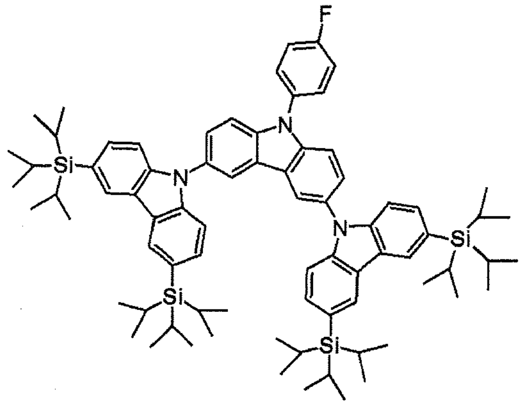

Formula (X),

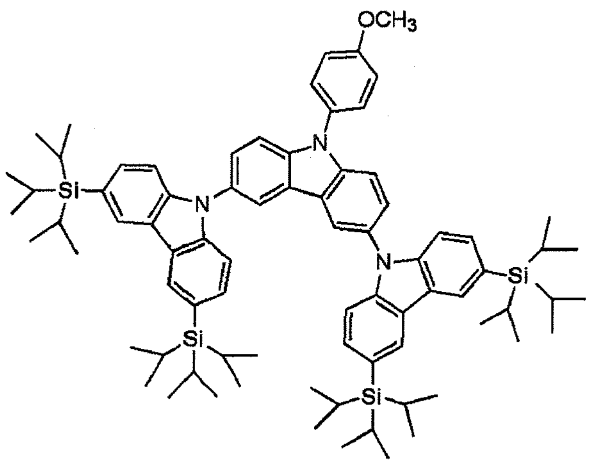

Formula (XI),

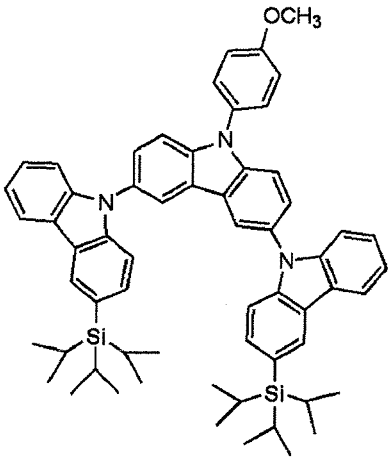

Formula (XII),

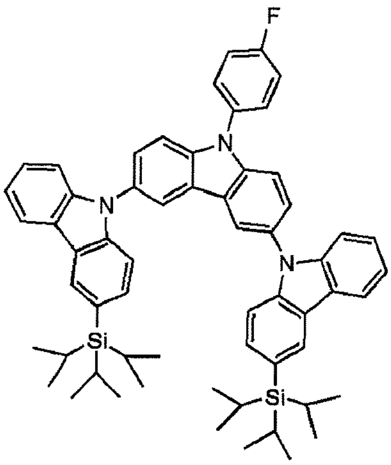

Formula (XIII),

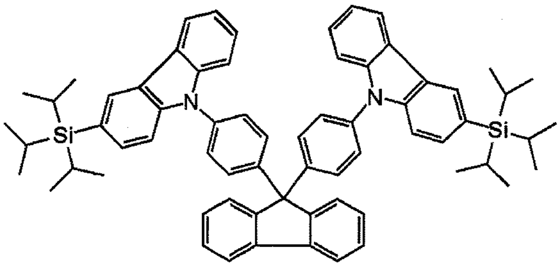

Formula (XIV),

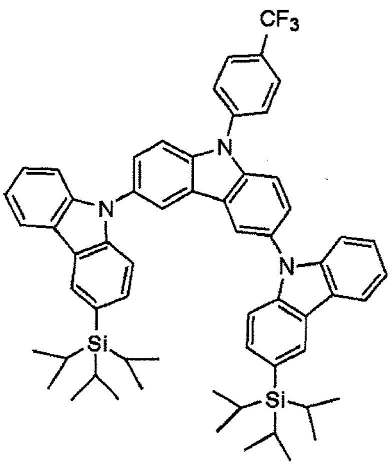

Formula (XV), and

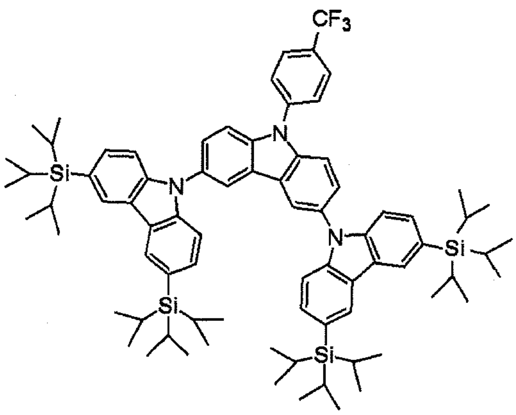

Formula (XVI).

The present invention is also directed to an OLED comprising an emissive layer, wherein the emissive layer comprises the oxadiazole-based compound as the host material described above. The OLED can also comprise an emissive material (where the light emissive material is present as a dopant), wherein the emissive material is adapted to luminescence when voltage is applied across the device.

Suitable guest emissive materials (dopant) can be selected from those known in the art and then developed including, without limitation, Ir or Pt complexes. In certain embodiments, bis(2-phenylpyridine)iridium complexes such as bis(3,5-difluoro-2-(2-pyridyl)phenyl-(2-carboxypyridyl))iridium III (FIrpic), which exhibit a phosphorescent emission in the blue region of the spectrum, can be used. In specific embodiments, the guest exhibits a phosphorescent emission in the pure blue region of the spectrum.

If the emissive material is used as a dopant in a host layer comprising the oxadiazole-based compound of the present invention, it is generally used in an amount of at least 1 wt%, specifically at least 3 wt%, and more specifically at least 5 wt%, with respect to the total weight of the host and the dopant. Further, it is generally used in an amount of at most 25 wt%, specifically at most 20 wt%, and more specifically at most 15 wt%.

The OLED generally comprises:

a glass substrate;
a generally transparent anode such as an indium-tin oxide (ITO) anode;
a hole transporting layer (HTL) and/or a hole injection layer (HIL);
an emissive layer (EML);
an electron transporting layer (ETL); and
a generally metallic cathode such as an Al layer.

For the hole conducting emissive layer, an exciton blocking layer, notably a hole blocking layer (HBL), may be present between the emissive layer and the electron transporting layer. For the electron conducting emissive layer, an exciton blocking layer, notably an electron blocking layer (EBL), may be present between the emissive layer and the hole transporting layer.

Optionally, the emissive layer may also contain a polarization molecule that is present as a dopant in the host material and has a dipole moment, which generally affects the wavelength of the light emitted when the light emitting material is used as a dopant luminescence.

The ETL may be used to transport electrons into the emissive layer comprising the light emitting material and the optional host material. The ETL may comprise an electron-transporting matrix selected from the group consisting of metal quinoxolates (e.g., $Alq_3$ and Liq), oxadiazoles, triazoles and imidazoles. Suitable examples of the electron transporting material are, without limitation, 2,2',2"-(1,3,5-benzinetriyl)-tris(1-phenyl-1-H-benzimidazole) ("TPBi") or tris-(8-hydroxyquinoline)aluminum ("$Alq_3$") of the following formula:

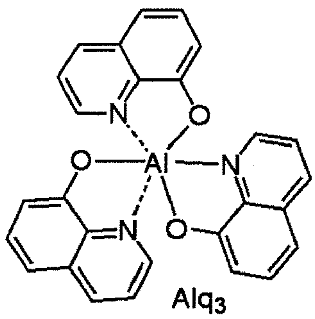

$Alq_3$

The HTL or HIL may be used to transport holes into the emissive layer comprising the light emitting material and the optional host material. The HTL or HIL may comprise, without limitation, polyethylenedioxythiophene:polystyrene sulfonate (PEDOT:PSS) or 4,4'-bis[N-(1-naphthyl)-N-phenylamino]biphenyl ("α-NPD") of the following formula:

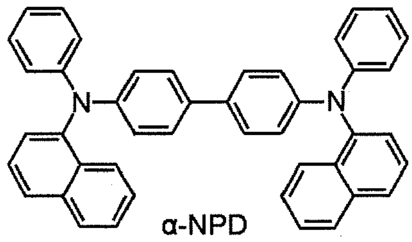

α-NPD

The use of the exciton blocking layer ("barrier layer") to confine excitons within the luminescent layer ("luminescent zone") may be advantageous. For a hole-transporting host, the blocking layer may be placed between the emissive layer and the electron transport layer. A suitable example of the material for the barrier layer, without limitation, is 2,9-dimethyl-4,7-diphenyl-1,10-phenanthroline (also referred to as bathocuproine or "BCP"), which has the following formula:

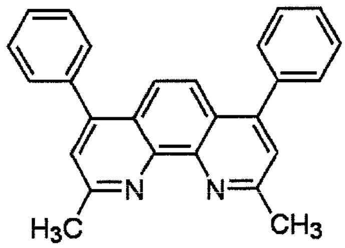

BCP

As depicted in Figure 1, in some embodiments, the OLED of the present invention has a multilayer structure, wherein: 1 is a glass substrate; 2 is an ITO layer; 3 is an HIL layer comprising PEDOT:PSS; 4 is an EML comprising host materials and the light emitting material as dopant; **5** is an ETL comprising TPBi; and **6** is an $Cs_2CO_3$/Al cathode layer.

Another aspect of the present invention relates to a process for manufacturing the organic light emitting device. According to the present methods, an emissive layer can be obtained by a solution deposition method. In some embodiments, the solution deposition method uses non-chlorinated solvents, such as acetone, dimethylbenzene, ethanol and toluene. In certain embodiments, toluene can be used as the solvent.

**Examples**

Hereinafter, the present invention will be explained in detail with reference to the examples and comparative examples. These examples, however, should not in any way be interpreted as limiting the scope of the present invention. Further, units are expressed by weight unless otherwise described.

**<u>Example 1</u> - Synthesis of tBu-OXD7 (Compound of Formula (II))**

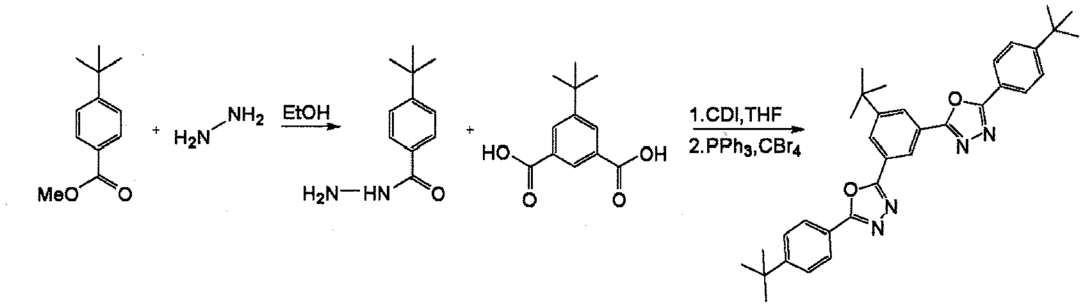


This synthesis has been formed in two steps, from commercially available methyl 4-tert-butylbenzoate ester and 5-tert-butylisophthalic acid.

**Step 1: Synthesis of 4-tert-butylbenzohydrazide:**

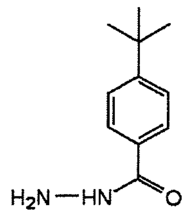

To 23 g of methyl 4-tert-butylbenzoate (120 mmol) in 250 mL of ethanol are added 40 g of hydrazine hydrate (600 mmol). The reaction mixture is heated to reflux during 20 hours. Half of the ethanol is removed under a reduced pressure and 500 mL of water is added. The extraction with $CH_2Cl_2$ (3*500 mL) and the evaporation of the organic phases afford 20 g of crude hydrazide.

Recrystallization from toluene affords 18 g of 4-tert-butylbenzohydrazide (yield = 78 %, NMR purity = 100 %).

**Step 2: Synthesis of tBu-OXD7:**

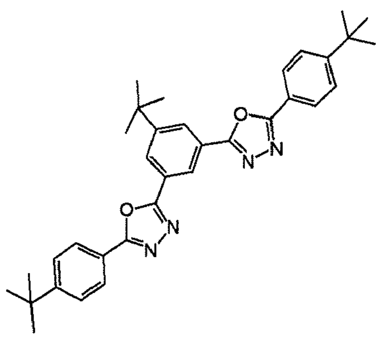

To 15 g of 5-tert-butylisophthalic acid (67.5 mmol) in 1 L of anhydrous THF (tetrahydro-furan) are added 24.1 g of 1,1'-carbonyldiimidazole (CDI - 148 mmol, 2.2 eq). After one hour at room temperature, 26 g of hydrazide are introduced (2 eq, 135 mmol) and the reaction medium is warmed to reflux. After one night, the medium is allowed to stand at room temperature. 71 g of $PPh_3$ (270 mmol) and 90 g of $CBr_4$ (270 mmol) are then added and the medium is warmed to 45 °C during 5 hours. The reaction mixture is then filtrated on silica gel and washed with THF. Purification by flash chromatography affords 22 g of crude tBu-OXD7. After recrystallization from toluene and vacuum sublimation,

15 g of pure tBu-OXD7 are collected (yield = 42 %, NMR purity >99.9 %, HPLC purity >99.9 %).

**Example 2 - Synthesis of $C_6F_{13}$-OXD7 (Compound of Formula (III))**

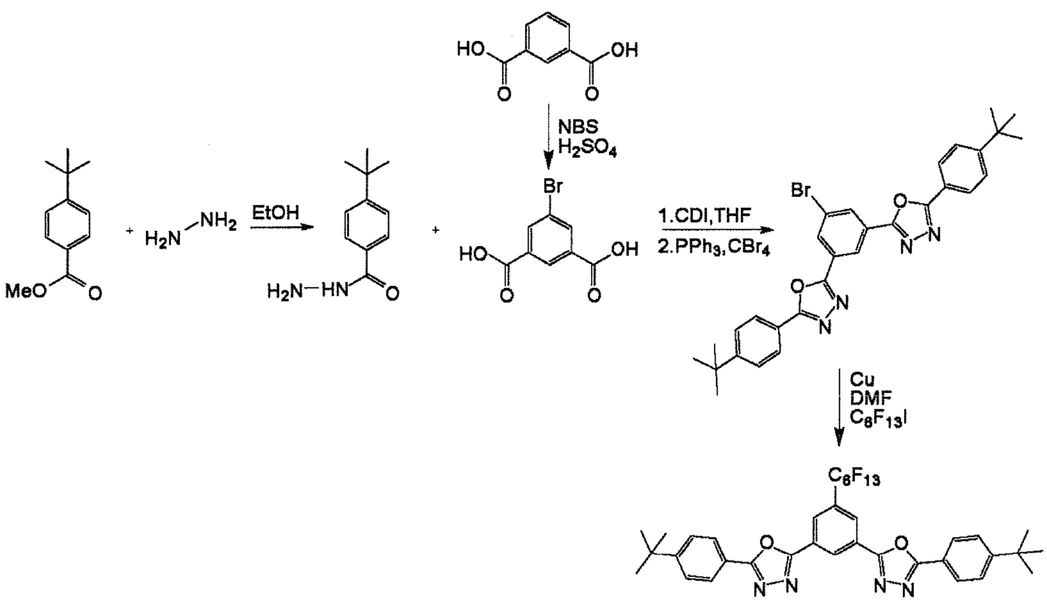


The bromo isophthalic acid is not commercially available and has to be prepared with NBS (N-bromosuccinimide) in $H_2SO_4$.

**Synthesis of 4-tert-butylbenzohydrazide**

This compound has been synthesised as described in Example 1.

**Synthesis of 5-bromoisophthalic acid**

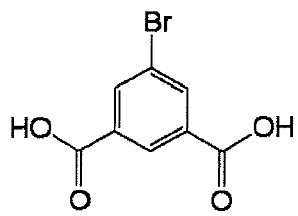

To 150 mL of $H_2SO_4$ in a 500 mL flask are added 60 g of isophthalic acid (361 mmol) and the reaction mixture is warmed to 50 °C. When this temperature is reached, 80 g of NBS (450 mmol) are added in three portions and the temperature is increased to 80 °C. The medium is then allowed to stand one night at room temperature. At the end of the reaction, ice is added (800 g) and the solid is recovered by filtration (110 g). This acid is purified by crystallization in 4.5 L of water. 75 g of pure 5-bromoisophthalic acid are then collected (yield = 85 %, NMR purity >98 %).

Synthesis of Br-OXD7

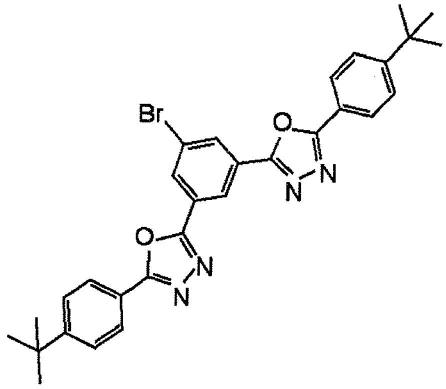

To 4 g of 5-bromoisophthalic acid (16.3 mmol) in 1 L of THF are added 6.7 g of CDI (35 mmol, 2.15 eq). After 4 hours at room temperature, 6.4 g of hydrazide are introduced (32.6 mmol, 2 eq) and the reaction medium is warmed to reflux. After one night, the medium is allowed to stand at room temperature. 17.1 g of $PPh_3$ (65.3 mmol) and 21.7 g of $CBr_4$ (65.3 mmol) are then added and the medium is warmed to 45 °C for 5 hours. The reaction mixture is then filtrated on silica gel and washed with THF. Purification by flash chromatography ($CH_2Cl_2$/THF) affords 7.7 g of crude Br-OXD7. Recrystallization from toluene/EtOH (5/4) affords 6.5 g of pure Br-OXD7 (11.7 mmol, yield = 71 %, NMR purity >99 %).

Synthesis of $C_6F_{13}$-OXD7

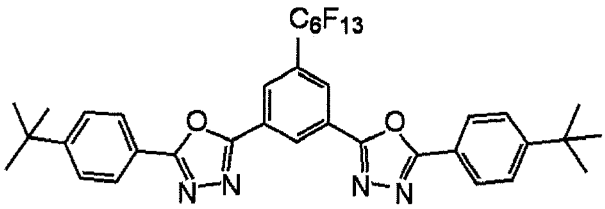

To 1 g of Br-OXD7 (1.8 mmol) and 350 mg of Cu (5.4 mmol) in 10 mL of dry DMF (dimethylformamide) at 130 °C are added 1.2 g of $C_6F_{13}I$ (2.7 mmol). After 20 hours at 130 °C, the reaction mixture is diluted with 20 mL of THF and filtrated over a silica gel pad. After evaporation and flash chromatography, 1.25 g of $C_6F_{13}$-OXD7 are recovered (1.6 mmol, yield = 87 %). A highly pure material can be obtained by sublimation (sublimation yield = 70 %, NMR purity >99.9 %, HPLC purity > 99.9 %).

**Example 3 - Synthesis of TCzF (Compound of Formula (VII))**

**Step 1: Synthesis of N-(4-fluorophenyl)-carbazole:**

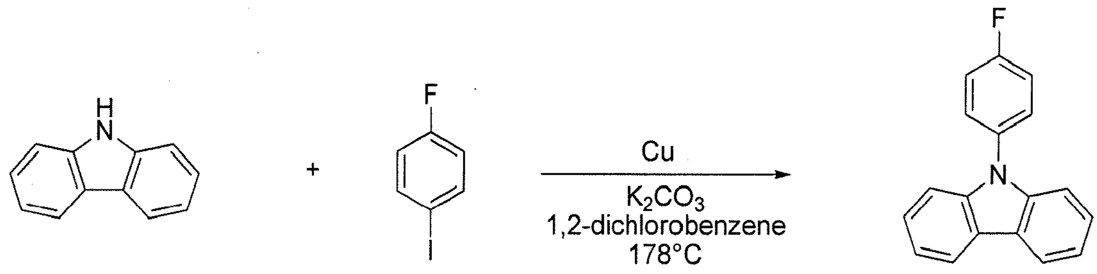


In a 2 L of three necked round bottom flask equipped with a condenser and a mechanical stirrer, 106.4 g (1.674 mol, 14 eq) of copper powder, 115.7 g (0.837 mol, 7 eq) of potassium carbonate, 1.58 g (60 mmol, 5 mol%) of 18-crown-6 ether, 39.83 g (0.179 mol, 1.5 eq) of 4-iodofluorobenzene and 20.0 g (0.120 mol, 1.0 eq) of carbazole are mixed in 1 L of dry 1,2-dichlorobenzene. The reaction medium is then stirred for 18 hours at 178°C. After cooling at room temperature, the solid is filtered off through a path of Celite ® 545, which is rinsed by 500 mL of toluene. The solvent is then removed from the filtrate under vacuum to give a light brown solid. This crude product is crystallized in ethanol to afford 24.1 g (0.0922 mol, yield = 77 %) of a white solid (99 % pure).

**Step 2: Synthesis of N-(4-fluorophenyl)-3,6-diiodocarbazole:**

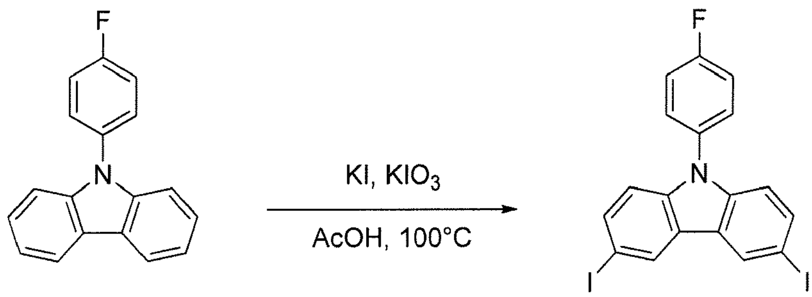


In a 500 mL of three necked round bottom flask equipped with a condenser and a mechanical stirrer, 20.0 g (0.0765 mol, 1.0 eq) of N-(4-fluorophenyl)-carbazole is dissolved in 200 mL of refluxing acetic acid. After cooling at 100°C, 16.77 g (0.0101 mol, 1.32 eq) of potassium iodide and 12.78 g (0.0597 mol, 0.78 eq) of potassium iodate are added. The reaction medium is stirred at 100°C for 2 hours and then cooled down at room temperature. The white precipitate is filtered, washed by 100 mL of 5 % aqueous sodium thiosulfate and 200 mL of water. After vacuum drying, 39.11 g (0.0762 mol, quantitative yield) of a white solid (92 % pure) is isolated and used without further purification in the next step.

**Step 3: Synthesis of N-(4-fluorophenyl)-3,6-bis(carbazol-9-yl)-carbazole:**

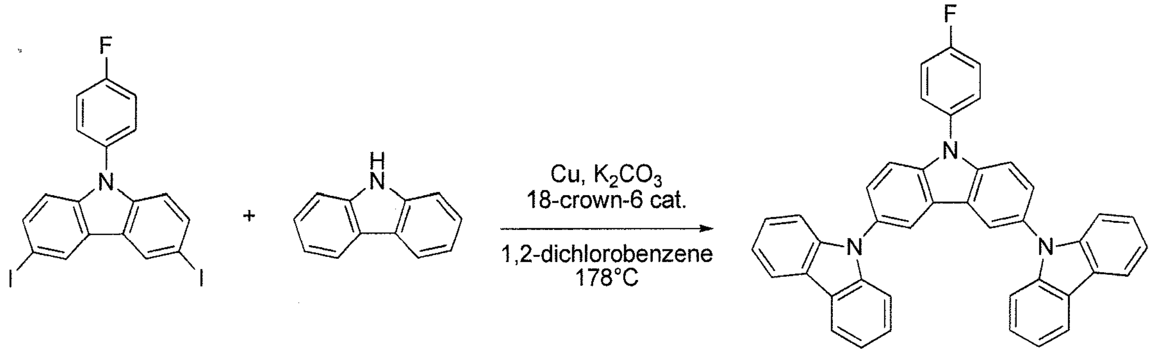


In a 1 L of three necked round bottom flask 104.0 g (1.637 mol, 28 eq) of copper powder, 96.97 g (0.702 mol, 12 eq) of potassium carbonate, 1.54 g (58 mmol, 10 mol%) of 18-crown-6 ether, 37.58 g (0.134 mol, 2.3 eq) of carbazole and 30.0 g (0.0585 mol, 1.0 eq) of N-(4-fluorophenyl)-3,6-diiodocarbazole are mixed in 500 mL of dry 1,2-dichlorobenzene. The reaction medium is stirred for 18 hours at 178°C.

After cooling at room temperature, the solid is filtered off through a path of Celite ® 545, which is rinsed by 200 mL of toluene. The solvent is then removed from the filtrate under vacuum to give a yellow-brown solid. This crude product is precipitated in chloroform/ethanol to collect 28.4 g (0.0480 mol, 82 % yield) of a pale white powder. Further sublimation affords N-(4-fluorophenyl)-3,6-bis(carbazol-9-yl)-carbazole as a >99 % pure white product.

**<u>Example 4</u> - Synthesis of TCz1 (Compound of Formula (VIII))**

**Step 1: Synthesis of N-(2-ethylhexyl)-3,6-dibromocarbazole:**

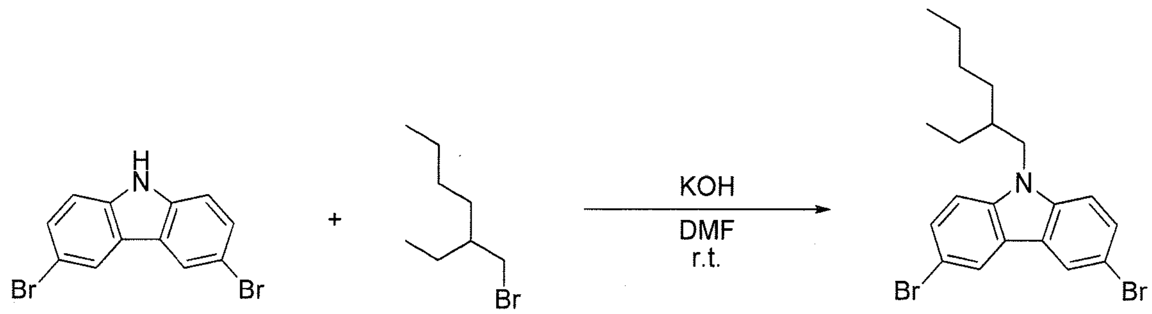


In a 500 mL of three necked round bottom flask equipped with a mechanical stirrer, 20.0 g (0.0615 mol, 1.0 eq) of 3,6-dibromocarbazole and 13.8 g (0.246 mol, 4.0 eq) of potassium hydroxide are stirred for 1h in 250 mL of N,N-dimethylformamide before addition of 14.26 g (0.0738 mol, 1.2 eq) of 2-ethylhexylbromide. The reaction is then mechanically stirred for 14 hours at room temperature and then poured in 100 mL of half saturated aqueous sodium bicarbonate solution. The aqueous layer is extracted by 2x200 mL of dichloromethane, the combined organic layers are dried over sodium sulfate and concentrated to give a crude light brown oil and further purified by flash chromatography to afford 23.39 g (0.0535 mol, 87% yield) of a colorless oil >99% pure.

**Step 2: Synthesis of N-(2-ethylhexyl)-3,6-bis(carbazol-9-yl)-carbazole:**

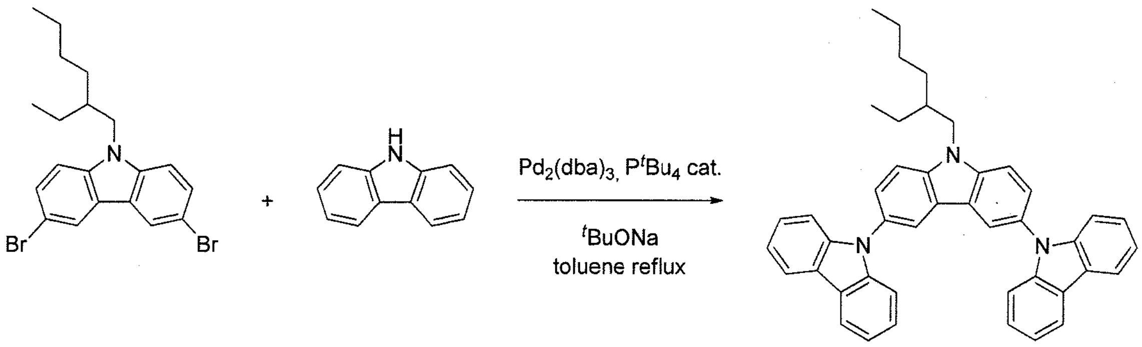


In a 250 mL of three necked round bottom flask equipped with a condenser and a mechanical stirrer, 5.15 g (0.0118 mol, 1.0 eq) ofN-(2-ethylhexyl)-3,6-dibromocarbazole, 4.92 g (0.0294 mol, 2.5 eq) of carbazole, 3.40 g (0.0353 mol, 3.0 eq) of sodium *tert*-butoxide, 270 mg (0.294 mmol, 2.5 mol%) of tris(dibenzylideneacetone)dipalladium(0) and 477 mg (2.36 mmol, 20 mol%) of tris(*tert*-butyl)phosphine are mixed in 150 mL of dry toluene. The reaction is then stirred at 110°C for 14 hours under nitrogen atmosphere and then cooled down at room temperature. The solid is filtered off through a path of Celite ® 545 which is rinsed by 200 mL of toluene. The solvent is then removed from the filtrate under vacuum to give a light brown solid and further purified by flash chromatography to afford 5,90 g (9,67 mmol, 82 % yield) of N-(2-ethylhexyl)-3,6-bis(carbazol-9-yl)-carbazole as a white solid >99 % pure.

**Example 5 - Solubility Tests**

As shown in the solubility measurement results in the table below, the compounds of Formulae II (tBu-OXD7) and III ($C_6F_{13}$-OXD7) have good solubilities toward chlorobenzene and toluene, while the control compound (OXD7) lacks solubility for most organic solvents.

The compounds of the present invention have been found to be promising for large-scale light emitting devices since they allow for solvent-processing techniques such as spin-coating, (ink-jet) printing, etc., while maintaining the other necessary properties for OLEDs.

**Table 1**

| | Solubility in chlorobenzene | Solubility in toluene |
|---|---|---|
| Comparative example (OXD7) | < 1.5 wt% | Not soluble |
| tBu-OXD7 | > 7.2 wt% | > 5 wt% |
| $C_6F_{13}$-OXD7 | > 4.5 wt% | 2.5 wt% |

**Example 6 - HOMO and LUMO measurement**

The LUMO (lowest unoccupied molecular orbital) levels are estimated from cyclic voltammetry. Voltammetric measurements are performed using a PC-controlled Autolab PGSTAT128N electrochemical workstation coupled with a 663 VA Stand measure unit. Cyclic voltammograms are recorded at room temperature under an argon atmosphere in anhydrous tetrahydrofuran using 0.1 M tetrabutylammonium hexafluorophosphate (Fluka electrochemical grade) as supporting electrolyte. The working electrode is a glassy carbon disk and the counter electrode is a platinum wire or a glassy carbon rod. A silver/silver chloride electrode filled with a methanolic saturated KCl solution or a platinum wire pseudo-reference has been used as reference electrode. The sample solutions (0.5 mM) are outgassed with argon for 10 minutes before measurement. Measurements are performed with a sweep rate fixed to 0.1 V/s. Ferrocene is used as internal standard.

The LUMO level is estimated from the peak potential of the 1st observed reduction wave ($E_1$ reduct.) using the following equation:

$$E_{LUMO} - (-4.8) = -[E_{1\ reduct.} - E_{ox\ ½}(Fc/Fc^{+})]$$

where $E_{HOMO}$ (ferrocene) has been taken equal to -4.8 eV below the vacuum level and $E_{OX\ 1/2}$ (Fc/$Fc^+$) corresponds to the half-wave oxidation potential of the ferrocene internal standard.

The HOMO level could not be estimated directly from CV measurements because the 1st oxidation wave lies beyond the stability window of the two tested solvents (tetrahydrofuran and dichloromethane). The HOMO level is thus estimated from the LUMO level and optical energy gap ($E_{opt\ g}$):

$$E_{HOMO} = E_{LUMO} - E_{opt\ g},$$

the optical energy gap being determined from the absorption onset in the UV-visible absorption spectrum.

As shown in the measurement results in the table below, the compounds (tBu-OXD7 and $C_6F_{13}$-OXD7) of the present invention have comparable electronic levels to the control compound (OXD7).

**Table 2**

| | HOMO | LUMO |
|---|---|---|
| Comparative example (OXD7) | -6.0 eV | -2.3 eV |
| tBu-OXD7 | -6.0 eV | -2.3 eV |
| $C_6F_{13}$-OXD7 | -6.1 eV | -2.5 eV |

**Example 7 - Preparation of OLED and Performance Measurement**

Figure 1 shows the general structure used to prepare OLEDs based on the inventive formulation.

To measure the effect of the *tert*-butyl substitution of OXD7, 2 devices with identical structure are fabricated. A reference device wherein the EML is spin-coated from an OXD7 formulation in chlorobenzene is compared to a test device wherein the EML is spin-coated from a tBu-OXD7 formulation in toluene.

The above devices are prepared as follows:

A HIL based on polyethylenedioxythiophene:polystyrene sulfonate (PEDOT:PSS purchased form HC Stack) is deposited by spin coating on indium tin oxide (ITO) coated glass substrates to a thickness of 60 nm. The obtained film is dried on a hot plate at 200°C for 10 minutes.

For the test device, the EML formulation comprises 35 % of TCzl (N-(2-ethylhexyl)-3,6-bis(carbazol-9-yl)-carbazole) as a hole transporting matrix, 60 % of tBu-OXD7 as an electron transporter matrix, 5 % of bis(3,5-difluoro-2-(2-pyridyl)phenyl-(2-carboxypyridyl))iridium III (Firpic purchased from Lumtec) as a blue phosphorescent emissive material and toluene as a solvent.

For the reference device, the EML formulation comprises 35 % of TCzl, 60 % of OXD7, 5 % of Firpic and chlorobenzene as a solvent. The total solid content is 1.5 wt%. Such formulation is deposited on top of the HIL by spin coating to a thickness of 70 nm and subsequently dried on a hot plate at 80°C for 10 minutes.

An 30 nm thick ETL, namely 2,2',2"-(1,3,5-benzinetriyl)-tris(1-phenyl-1-H-benzimidazole) (TPBi, purchased from Lumtec), is deposited by vacuum deposition onto the EML at a rate of 2 Å/s.

Finally, cathode layers comprising 1 nm of $Cs_2CO_3$ and 100 nm of Al are deposited by thermal evaporation at a rate of 0.1 and 2 Å/s, respectively.

Electronic and photometric characterizations are conducted with a Hamamatsu C9920-12 measurement system coupled to a Keithley 2400 source measure unit.

All device preparation and characterization steps after deposition of PEDOT:PSS by spin coating are carried out in an inert atmosphere.

Figure 2 shows the I-V-L characteristics of the two devices. Both devices show similar current density and luminance with slightly higher values for the OXD7 formulation. Turn-on voltages are 3.4V and 3.6V for the OXD7 and tBu-OXD7 formulation, respectively.

Figure 3 shows the luminous efficiency as a function of the luminance.

The device based on tBu-OXD7 shows a clear improvement of the performance when compared to the reference device based on OXD7. At 1000 cd/$m^2$, both luminous efficiency and power efficiency are increased from 13.6 cd/A and 5.9 lm/W with OXD7 to 16.3 cd/A and 7.0 lm/W with tBu-OXD7. Further, external quantum efficiency (EQE) is increased from 6.3 % with OXD7 to 7.7 % with tBu-OXD7. The results of the performance measurements are summarized in the following table. The parameters "x" and "y" represents the color indexes.

**Table 3**

| ETM | HTM | Solution | V | EQE | Lm/W | Cd/A | x | y |
|---|---|---|---|---|---|---|---|---|
| Comparative example (60 % OXD7) | TCzl | Chlorob enzene | 7.3 | 6.3 | 5.9 | 13.6 | 0.17 | 0.37 |
| 60 % tBu-OXD7 | TCzl | Toluene | 7.4 | 7.7 | 7.0 | 16.3 | 0.16 | 0.36 |

Replacing TCzl by TCzF in the EML formulation (60 % of tBu-OXD7, 35 % of TCzF, 5 % of FIrpic) in toluene gives a similar luminous efficiency (16.0 cd/A at 1000 cd/$m^2$) and a slightly higher power efficiency (7.2 lm/W) compared to those of TCz1. Additional results of the performance measurements (at 1000 cd/$m^2$) with varying the solution, the electron transporting material (ETM) and the hole transporting material (HTM) are summarized in the following table.

**Table 4**

| ETM | HTM | Solution | V | EQE | Lm/W | Cd/A |
|---|---|---|---|---|---|---|
| tBu-OXD7 | TCzF | Toluene | 6.9 | 7.4 | 7.2 | 16.0 |
| Comparative example (OXD7) | TCzF | Chlorobenzene | 7.5 | 6.0 | 5.6 | 13.3 |
| tBu-OXD7 | TCzF | Chlorobenzene | 7.7 | 6.5 | 5.7 | 14.0 |

It will be apparent to those skilled in the art that various modifications and variations can be made to the present invention without departing from the spirit and scope of the invention. Thus, it is intended that the present disclosure covers the modifications and variations of this invention, provided they come within the scope of the appended claims and their equivalents.

## Claims

1. An organic light emitting device comprising a compound of Formula I as an electron transporting material in an emissive layer:

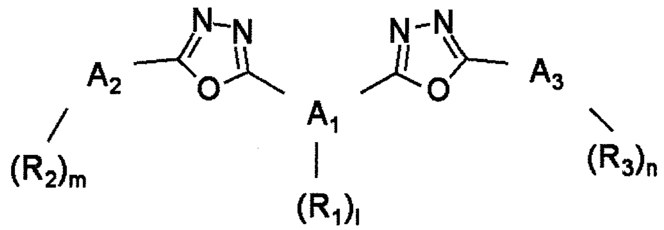

Formula (I)

wherein:

$A_1$, $A_2$ and $A_3$ are same or different at each occurrence and independently selected from the group consisting of five- or six-membered (hetero)aryl rings and fused rings;
$R_1$ is selected from the group consisting of halogen, nitro, cyano, straight or branched $C_{1-20}$-(hetero)alkyl, straight or branched $C_{2-20}$-(hetero)alkenyl, straight or branched $C_{2-20}$ -(hetero)alkynyl, $C_{3-20}$ -cyclic alkyl, straight or branched $C_{1-20}$ alkoxy, $C_{1-20}$ -dialkylamino, $C_{4-14}$ -(hetero)aryl and $C_{4-14}$ -aryloxy, which are substitutable by one or more halogens or non aromatic radicals;
$R_2$ and $R_3$ are same or different at each occurrence and independently selected from the group consisting of -H, halogen, nitro, cyano, straight or branched $C_{1-20}$ -alkyl, straight or branched $C_{2-20}$ -alkenyl, straight or branched $C_{2-20}$ -alkynyl, $C_{3-20}$ -cyclic alkyl, straight or branched $C_{1-20}$ -alkoxy, $C_{1-20}$ -dialkylamino, $C_{4-14}$ -aryl, $C_{4-14}$ -aryloxy and $C_{4-14}$ -heteroaryl, which are substitutable by one or more non aromatic radicals, wherein a plurality of $R_1$, $R_2$ and $R_3$ may in turn together form a mono- or polycyclic ring, optionally aromatic; and
1, m and n are same or different at each occurrence and represent an integer of 1 or more.

**2.** The organic light emitting device of Claim 1, wherein $A_1$ is phenyl.

**3.** The organic light emitting device of Claim 1 or 2, wherein $A_2$ and $A_3$ are phenyl.

**4.** The organic light emitting device of any one of the preceding Claims, wherein $R_1$ is straight or branched $C_{1-20}$ -(hetero)alkyl, $C_{3-20}$ -cyclic alkyl and $C_{4-14}$ -(hetero)aryl, which are substitutable by one or more halogen, hydroxyl, nitro, cyano, alkoxy, amino and optionally-esterified carboxyl.

**5.** The organic light emitting device of Claim 4, wherein $R_1$ is a *tert*-alkyl, fluorinated alkyl or fluorinated ether and wherein 1 is 1.

**6.** The organic light emitting device of any one of the preceding Claims, wherein $R_2$ and $R_3$ are same or different at each occurrence and independently straight or branched $C_{1-20}$ -alkyl, $C_{3-20}$ -cyclic alkyl, straight $C_{4-14}$ -aryl and $C_{4-14}$-heteroaryl.

**7.** The organic light emitting device of Claim 6, wherein $R_2$ and $R_3$ are *tert*-butyl, and wherein m and n are 1.

**8.** The organic light emitting device of any of the preceding Claims, wherein the compound has the following formula:

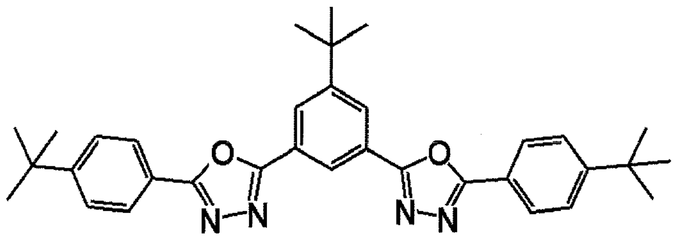

Formula (II), or

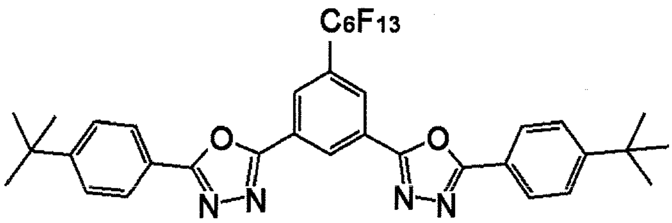

Formula (III).

**9.** The organic light emitting device of any one of the preceding Claims, wherein the emissive layer further comprises a phosphorescent emissive material.

**10.** The organic light emitting device of Claim 9, wherein the phosphorescent emissive material is an Ir or Pt complex.

**11.** The organic light emitting device of any one of the preceding Claims, wherein the emissive layer further comprises a carbazole derivative as a hole transporting material.

**12.** The organic light emitting device of Claim 11, where the carbazole derivative is a triscarbazole (TCz) derivative.

**13.** The organic light emitting device of Claim 12, where the TCz is TCzF (compound of formula VII) or TCzl (compound of formula VIII):

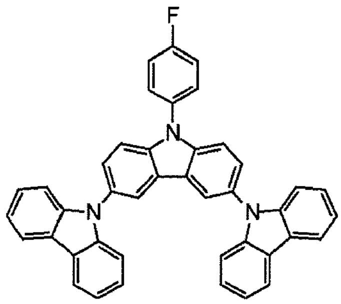

Formula (VII)

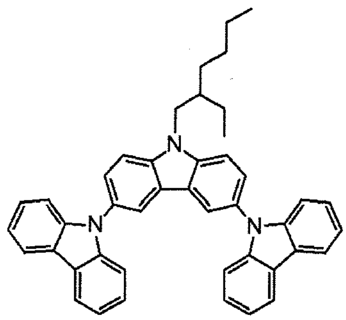

Formula (VIII) .

14. A process for manufacturing an organic light emitting device of any one of the preceding Claims, according to which the emissive layer is obtained by a solution deposition method.

15. The process according to Claim 14, wherein the solution deposition method uses a non chlorinated solvent.

Fig. 1

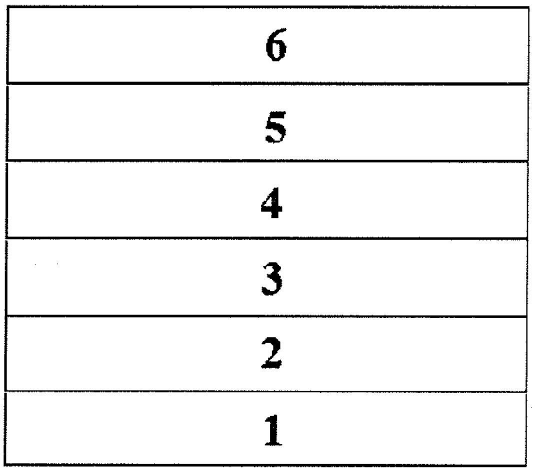
6
5
4
3
2
1

Fig. 2

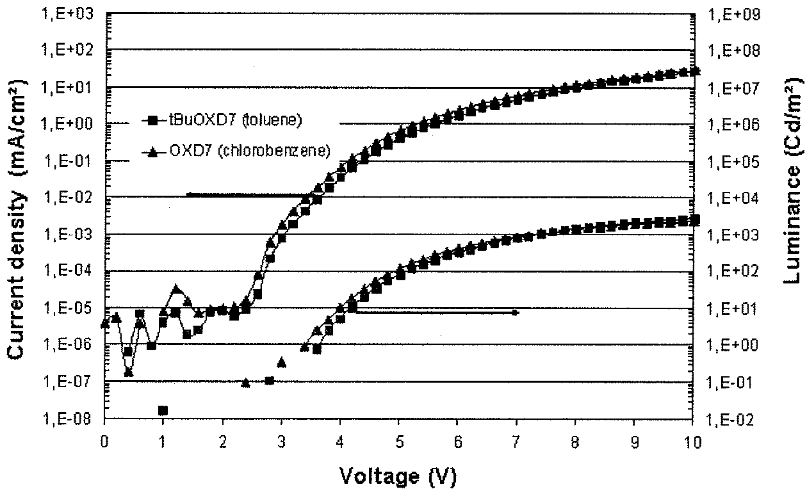
Current density (mA/cm²)
Luminance (Cd/m²)
Voltage (V)
tBuOXD7 (toluene)
OXD7 (chlorobenzene)
1,E+03
1,E+02
1,E+01
1,E+00
1,E-01
1,E-02
1,E-03
1,E-04
1,E-05
1,E-06
1,E-07
1,E-08
1,E+09
1,E+08
1,E+07
1,E+06
1,E+05
1,E+04
1,E+03
1,E+02
1,E+01
1,E+00
1,E-01
1,E-02
0
1
2
3
4
5
6
7
8
9
10

Fig. 3

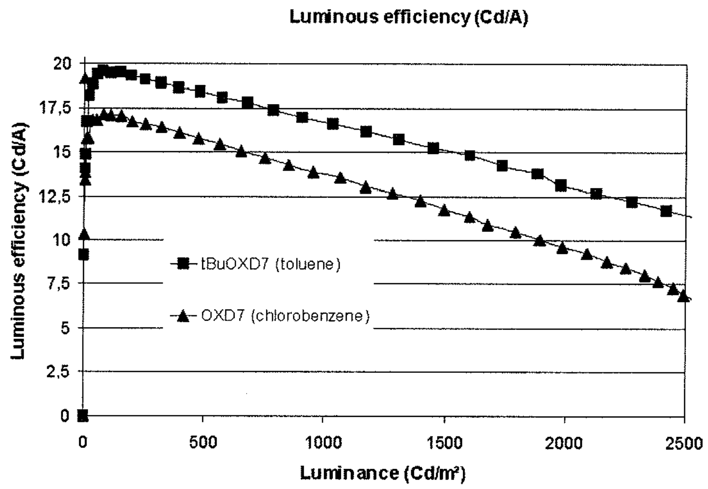
Luminous efficiency (Cd/A)
Luminous efficiency (Cd/A)
20
17,5
15
12,5
10
7,5
5
2,5
0
0
500
1000
1500
2000
2500
Luminance (Cd/m²)
tBuOXD7 (toluene)
OXD7 (chlorobenzene)

Europäisches Patentamt
European Patent Office
Office européen des brevets

# EUROPEAN SEARCH REPORT

Application Number
EP 09 16 7477

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/287396 A1 (NAKAMURA TETSUO [JP] ET AL) 29 December 2005 (2005-12-29)<br>* paragraph [0138]; figures OXD-1 structure *<br>* paragraph [0117] - paragraph [0125] *<br>* paragraph [0134] - paragraph [0136]; example comparative ex 6; table 1 *<br>----- | 1-15 | INV.<br>H01L51/00 |
| X | ZHANG ET AL: "Synthesis and characterization of 1,3,4-oxadiazole derivatives containing alkoxy chains with different lengths"<br>JOURNAL OF MOLECULAR STRUCTURE, ELSEVIER, AMSTERDAM, NL,<br>vol. 846, no. 1-3,<br>31 October 2007 (2007-10-31), pages 55-64, XP022323997<br>ISSN: 0022-2860<br>* page 56; figure scheme 2 *<br>* page 63, column 1, line 8 - line 9 *<br>----- | 1-3,6 | |
| X | AHN J ET AL: "Organic light-emitting diodes based on a blend of poly[2-(2-ethylhexyloxy)-5-methoxy-1,4-phenylenevinylene] and an electron transporting material"<br>APPLIED PHYSICS LETTERS, AIP, AMERICAN INSTITUTE OF PHYSICS, MELVILLE, NY, US,<br>vol. 85, no. 7,<br>1 January 2004 (2004-01-01), pages 1283-1285, XP012064270<br>ISSN: 0003-6951<br>* page 1284; figure scheme 1 *<br>* page 1283, column 1, line 1 - column 2, line 25 *<br>-----<br>-/-- | 1,3-4,<br>6-7,14 | TECHNICAL FIELDS SEARCHED (IPC)<br>H01L |

The present search report has been drawn up for all claims

1

| Place of search | Date of completion of the search | Examiner |
|---|---|---|
| The Hague | 26 January 2010 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.....................................................
& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 09 16 7477

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ANTONIADIS HOMER ET AL: "Blue-green organic light-emitting diodes based on fluorene-oxadiazole compounds" APPLIED PHYSICS LETTERS, AIP, AMERICAN INSTITUTE OF PHYSICS, MELVILLE, NY, US, vol. 73, no. 21, 23 November 1998 (1998-11-23), pages 3055-3057, XP012021467 ISSN: 0003-6951 * figures 1,3; table 1 * ----- | 1,3-4 | |
| X | LI H ET AL: "The synthesis, optical properties and x-ray crystal structure of novel 1,3,4-oxadiazole derivatives carrying a thiophene unit" DYES AND PIGMENTS, ELSEVIER APPLIED SCIENCE PUBLISHERS. BARKING, GB, vol. 80, no. 1, 1 January 2009 (2009-01-01), pages 163-167, XP025479423 ISSN: 0143-7208 [retrieved on 2008-07-04] * page 166, column 2, line 22 - line 26; figure 1 * ----- | 1,14 | TECHNICAL FIELDS SEARCHED (IPC) |

The present search report has been drawn up for all claims

1

| Place of search | Date of completion of the search | Examiner |
|---|---|---|
| The Hague | 26 January 2010 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 09 16 7477

This annex lists the patent family members relating to the patent documents cited in the above-mentioned European search report.
The members are as contained in the European Patent Office EDP file on
The European Patent Office is in no way liable for these particulars which are merely given for the purpose of information.

26-01-2010

| Patent document cited in search report | Publication date | Patent family member(s) | Publication date |
|---|---|---|---|
| US 2005287396 A1 | 29-12-2005 | JP 2006013222 A | 12-01-2006 |

EPO FORM P0459

For more details about this annex : see Official Journal of the European Patent Office, No. 12/82